Europäisches Patentamt

European Patent Office

Office européen des brevets

(19)

(11) **EP 1 178 543 A1**

(12) **EUROPEAN PATENT APPLICATION**

(43) Date of publication:
**06.02.2002 Bulletin 2002/06**

(51) Int Cl.7: **H01L 33/00**, H01S 5/327,
H01S 5/347

(21) Application number: **01115378.0**

(22) Date of filing: **26.06.2001**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **27.06.2000 JP 2000193525**

(71) Applicants:
- **National Institute of Advanced Industrial
  Science and Technology
  Tokyo 100-8901 (JP)**
- **ROHM CO., LTD.
  Kyoto 615 (JP)**

(72) Inventors:
- **Iwata, Kakuya
  Tsukuba-city, Ibaraki (JP)**
- **Fons, Paul
  Tsukuba-city, Ibaraki (JP)**
- **Matsubara, Koji
  Tsukuba-city, Ibaraki (JP)**
- **Yamada, Akimasa
  Inashiki, Ibaraki (JP)**
- **Niki, Shigeru
  Tsukuba-city, Ibaraki (JP)**
- **Nakahara, Ken, c/oRohm Co. Ltd.
  Kyoto-shi (JP)**

(74) Representative:
**Leson, Thomas Johannes Alois, Dipl.-Ing.
Tiedtke-Bühling-Kinne & Partner GbR,
TBK-Patent, Bavariaring 4
80336 München (DE)**

(54) **Semiconductor light emitting device**

(57) In such a construction that an active layer (5) for emitting light when a current is injected thereto is sandwiched between an n-type clad layer (4) and a p-type clad layer (6) which are made of a material having a larger band gap than that of the active layer, the above-mentioned active layer (5) is made of a compound semiconductor containing Zn, o, and a group VI type element other than O As a result, it is possible to obtain such a semiconductor light emitting device as a blue type LED or LD, which is made of the harmless material and does not include Cd specifically, while using a ZnO-based compound semiconductor of narrow band gap with fewer crystal defects and excellent in crystallinity as a material of its active layer sandwiched between clad layers, and also improving its light emitting properties.

FIG. 1

EP 1 178 543 A1

**Description**

FIELD OF THE INVENTION

The present invention relates to a semiconductor light emitting device which emits light even with a short wavelength of a blue-band color ranging from ultraviolet to yellow, such as a light emitting diode (hereinafter abbreviated as LED) used in a light source including a full-color display or a signal light, or a semiconductor laser (hereinafter abbreviated as LD) used in a next-generation high-definition DVD light source which continuously oscillates at a room temperature. More particularly, the present invention relates to a semiconductor light emitting device having an active layer made of ZnO-based compound semiconductor which has a narrowed band gap and excellent crystallinity.

BACKGROUND OF THE INVENTION

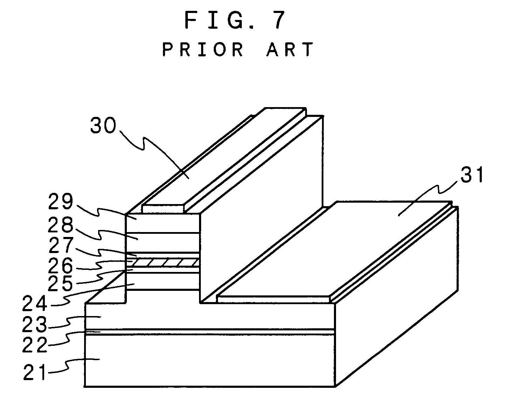

Recently, a blue type (which hereinafter means a color band of ultraviolet to near-yellow) LED or LD can be obtained by laminating GaN-based compound semiconductor layers on a sapphire substrate, thus attracting the attention. This sort of a conventional blue type semiconductor light emitting device is made, as shown for example in FIG. 7 showing a configuration of one example of LD, by sequentially laminating group III nitride compound semiconductor (GaN-based compound semiconductor) layers on a sapphire substrate 21 by Metal Organic Chemical Vapor Deposition (hereinafter abbreviated as MOCVD), in which a GaN buffer layer 22, an n-type contact layer 23 made of n-type GaN, an n-type clad layer 24 made of $Al_{0.12}Ga_{0.88}N$, an n-type light guide layer 25 made of GaN, an active layer 26 having a multiple-quantum well structure made of an In-GaN-based compound semiconductor, a p-type light guide layer 27 made of p-type GaN, a p-type clad layer 28 made of p-type $Al_{0.12}Ga_{0.88}N$, and a p-type contact layer 29 made of p-type GaN are sequentially laminated.

And thus laminated semiconductor layers are, as shown in FIG. 7, partially etched by dry-etching or the like to expose the n-type contact layer 23, and an n-side electrode 31 and a p-side electrode 30 are provided on the surfaces of the n-type contact layer 23 and the p-type contact layer 29, respectively.

A ZnO-based compound semiconductor, on the other hand, has its exciton (pair of an electron and a hole bound by the Coulomb force) having a very large combination energy (binding energy) of 60 meV, which is larger than the heat energy at room temperature of 26 meV, so that the exciton can exist in a stable manner even at room temperature. This exciton, once formed, generates a photon easily. That is, it emits light effectively. Accordingly, it is known that the exciton will emit light much more effectively than emission by direct recombination, by which a free electron and a free hole are directly recombined with each other. This has led to a research of a semiconductor light emitting device made of ZnO-based compound semiconductor.

The ZnO compound, however, has a band gap of 3.2 eV, so that when it is used as is to form an active layer, light can be emitted only in the vicinity of 370, nm in an ultraviolet region of wavelengths. To use the material as a light source for a high-definition DVD, for example, it must meet the two requirements of a transmission factor of an optical disk substrate and a recording density on the disk, so that the wavelength of that light source must be in a range of 400-430 nm. Accordingly, the band gap of ZnO must be narrowed and therefore it is discussed to mix a CdO crystal into a ZnO crystal in order to narrow the band gap in a prior art ZnO-based compound semiconductor, and to use a CdZnO-based compound ("CdZnO-based" means that the crystal mixture ratio of Cd and Zn is variable) as a material of an active layer.

The group III nitride compound semiconductor (gallium nitride based compound semiconductor) used for such a blue type semiconductor light emitting device which has a short wavelength is very stable thermally and chemically and also highly reliable, being excellent in a long life. To be stable, however, the semiconductor must be grown at a high temperature of 1000 °C or so in order to form a semiconductor layer excellent in crystallinity. A semiconductor layer such as an active layer containing In, on the other hand, is difficult to mix element In and GaN and also the element In has a high vapor pressure, so that to contain a sufficient quantity of In, the layer can be grown only at about 700 °C or lower. This property of In disables growing at a high temperature required for making a semiconductor layer excellent in crystallinity to thereby prevent it from forming the excellent layer in crystallinity, thus leading to problems of the deteriorated light emitting efficiency and the shortened life.

To narrow the band gap using a ZnO-based compound semiconductor, on the other hand, as mentioned above, a CdZnO-based compound may possibly be employed but Cd is highly toxic, so that any other materials with better safety are desired.

SUMMARY OF THE INVENTION

In view of the above, it is an object of the present invention to provide a semiconductor light emitting device that can narrow the band gap of a ZnO-based material and that can be improved in its light emitting properties by employing a ZnO-based compound semiconductor with fewer crystal defects and excellent in crystallinity as a material of an active layer of the device including a blue type light emitting diode or laser diode in which the active layer is sandwiched by clad layers.

Another object of the present invention is to provide a blue type emitting semiconductor laser which can be used as a high-definition DVD light source.

The inventors greatly investigated to obtain a semiconductor light emitting device mainly made of ZnO-based compound by narrowing their band gap without using Cd and found as a result that by replacing O of ZnO partially with any other group VI element such as S or Se in growth, such a mixed crystal as $ZnO_{1-x}S_x$ (0<x<1) or $ZnO_{1-y}Se_y$ (0<y<1) can be formed and also that by utilizing a band gap bowing phenomenon at the time of crystal mixture, the band gap can be narrowed to a desired range. Here, a ZnO-based compound refers to a compound containing at least Zn and O in which Zn is replaced partially with a group II element such as Mg or Cd and/or a compound in which O is replaced partially with any other group VI element such as s or Se.

That is, it is found that when the element S or Se is mixed into ZnO, the band gap changes drastically, so that if its crystal mixture rate is too high, the properties of ZnS or ZnSe become dominant and if it is too low, the properties of ZnO become dominant, thus failing to obtain a desired band gap; however, a mixed crystal with a finely controlled crystal mixture rate has such a property that its band gap changes in bowing (i.e., in a bow shape or parabola shape), so that by finely controlling the crystal mixture ratio at a portion where the band gap changes in bowing, a desired band gap can be obtained.

To emit light over the above-mentioned wavelength range of 400-430 nm, the crystal mixture ratio x of S is preferably 0.02-0.1 and more preferably 0.03-0.06, while the crystal mixture ratio y of Se is preferably 0.005-0.1 and more preferably 0.008-0.04, thus being well suited for the above-mentioned application.

The semiconductor light emitting device according to the present invention comprises an active layer for emitting light when a current injected thereto and n-type and p-type clad layers which are made of a material having a larger band gap than the active layer and which sandwich the active layer between both faces thereof, in which the active layer is formed of a compound semiconductor containing Zn, O, and at least one of other group VI elements than O.

This construction makes it possible to narrow the band gap than in a case of using ZnO and control over the crystal mixture ratio of group VI element other than O makes it possible to obtain a semiconductor layer with good crystallinity of its active layer having a band gap for emitting light of a desired wavelength, thus obtaining a semiconductor light emitting device with a high light emitting efficiency. It is also possible to mix a group VI element other than O in a mixed crystal compound in which Zn of ZnO is partially replaced with Cd or Mg. In this case, Cd acts to narrow the band gap and Mg acts to widen it, so that the desirable crystal mixture rate is shifted from the above-mentioned x and y values.

Specifically, the above-mentioned clad layer may be formed of an oxide compound containing Zn, an oxide compound semiconductor containing Mg and Zn, or a group III nitride compound semiconductor, while the above-mentioned active layer may be formed of

$ZnO_{1-x}S_x$ (0<x<1) or $ZnO_{1-y}Se_y$ (0<y<1). That is, even in the case of a semiconductor light emitting device made of a group III nitride compound semiconductor, although its active layer does not have good crystallinity as mentioned above but it is possible to use a compound semiconductor containing Zn, O, and a group VI element other than O according to the present invention only in that active layer.

Here, the term of a group III nitride compound semiconductor, also called a gallium nitride based compound semiconductor, refers to a semiconductor made of a compound of a group III element Ga and a group V element N, or a compound in which a part or the whole of a group III element Ga is replaced with another group III element such as Al or In, and/or a compound in which a part of a group V element N is replaced with another group V element such as P or As.

The above-mentioned active layer may be a semiconductor layer containing ZnO, O, S, and Se.

In a case where the above-mentioned semiconductor light emitting device is a semiconductor laser, the above-mentioned active layer may be formed of a bulk layer made of $ZnO_{1-x}S_x$ or $ZnO_{1-y}Se_y$, or a quantum well structure obtaining by modifying the composition of $ZnO_{1-x}S_x$ or $ZnO_{1-y}Se_y$. The bulk layer here refers to a one that its active layer as a whole has a uniform composition.

The above-mentioned active layer may have light guide layers on its both sides. Also, the structure for defining a current injecting region in the active layer may be of an electrode stripe type in which an electrode provided on the surface of a semiconductor lamination is formed in a stripe, or a mesa stripe type in which a mesa type shape is formed from the surface of a semiconductor lamination to part of an upper side clad layer, or a SAS type in which a current restricting layer having a stripe groove is formed in either one of clad layers of a semiconductor lamination.

If the substrate on which a semiconductor lamination including the above-mentioned n-type clad layer, the active layer, and the p-type clad layer is formed is electrically conductive, one electrode of the two can be formed on the back side of the substrate, thus facilitating the manufacturing processes and also obtaining a vertical type device. The term of "conductive" includes the semiconductor in which the series resistance matters little.

BRIEF DESCRIPTION OF THE DRAWINGS

FIG. 1 is a perspective view for explaining one embodiment of a semiconductor light emitting device according to the present invention;
FIG. 2 is a perspective view for explaining another embodiment of the semiconductor light emitting device according to the present invention;

FIG. 3 is a perspective view for explaining a further embodiment of the semiconductor light emitting device according to the present invention;

FIG. 4 is a perspective view for explaining still further embodiment of the semiconductor light emitting device according to the present invention;

FIG. 5 is a perspective view for explaining an additional embodiment of the semiconductor light emitting device according to the present invention;

FIG. 6 is a graph for explaining a state where ZnOS and ZnOSe generate the bowing phenomenon in the band gap by varring the crystal mixture ratio; and

FIG. 7 is a cross-sectional view for showing one example of a prior art blue type semiconductor laser.

## DETAILED DESCRIPTION

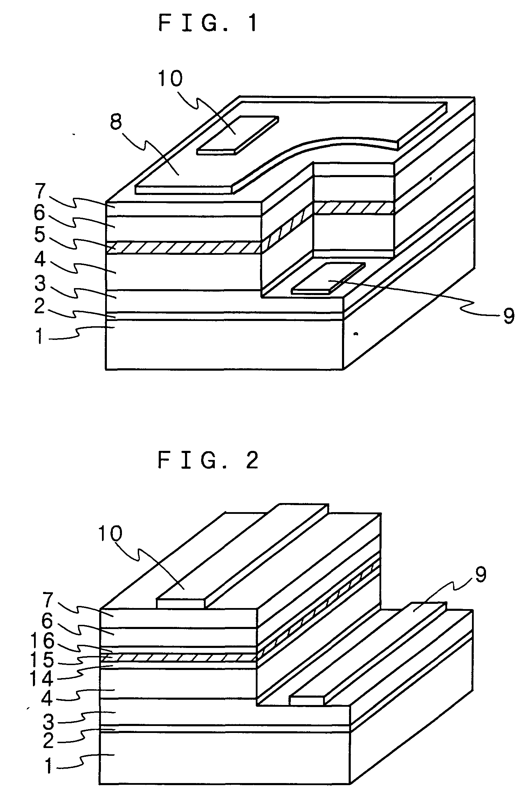

As shown in FIG. 1 for showing a perspective view of an LED chip of its one embodiment, a semiconductor light emitting device according to the present invention has such a configuration that an active layer 5 for emitting light when a current is injected thereto is sandwiched between an n-type clad layer 4 and a p-type clad layer 6 made of a material having a lager band gap than that of the active layer 5, in which the above-mentioned active layer 5 is made of a compound semiconductor containing Zn, O, and a group VI element other than O.

The active layer 5 emits light when carriers are recombined and its band gap determines a wavelength of the light emitted, so that it is made of a material of the band gap corresponding to a desired value of the wavelength, and is formed in a thickness of 0.1 $\mu$m or so by e.g. a bulk layer. The invention features that this active layer 5 is made of a compound semiconductor containing Zn, O, and a group VI element other than O as designated for e.g. $ZnO_{1-x}S_x$ (0<x<1: e.g. x = 0.05).

That is, as mentioned above, gallium nitride based compound semiconductor has been employed in a prior art blue type semiconductor light emitting device in which an active layer is sandwiched between clad layers having a larger band gap than that of the clad layer and the active layer has been made of an InGaN-based (which means that a crystal mixture ratio of In can be changed so as to provide a desired band gap) compound semiconductor. But the InGaN-based compound semiconductor, as mentioned above, has poor crystallinity and cannot set the crystal mixture ratio of In at a constant level or higher and so is not able to emit light having a long wavelength of a certain value or larger. Also, when a ZnO-based compound semiconductor is employed, it is necessary to mix a Cd crystal in order to narrow the band gap, thus giving rise to a problem of high toxicity.

The inventors greatly investigated and eventually found that, to narrow the band gap of the ZnO-based compound without using Cd as described above, O of ZnO can be partially replaced in growing with a group VI element other than O such as S or Se to thereby form a mixed crystal such as $ZnO_{1-x}S_x$ (0<x<1) or $ZnO_{1-y}Se_y$ (0<y<1) and also the band gap can be adjusted in the desired value by using the bowing phenomenon at the time of growing the mixed crystal to thereby narrow the band gap to a desired range.

That is, the band gap Eg(x) of a general compound $AB_{1-p}C_p$ is expressed as follows:

$$Eg(x) = a+bx+cx^2$$

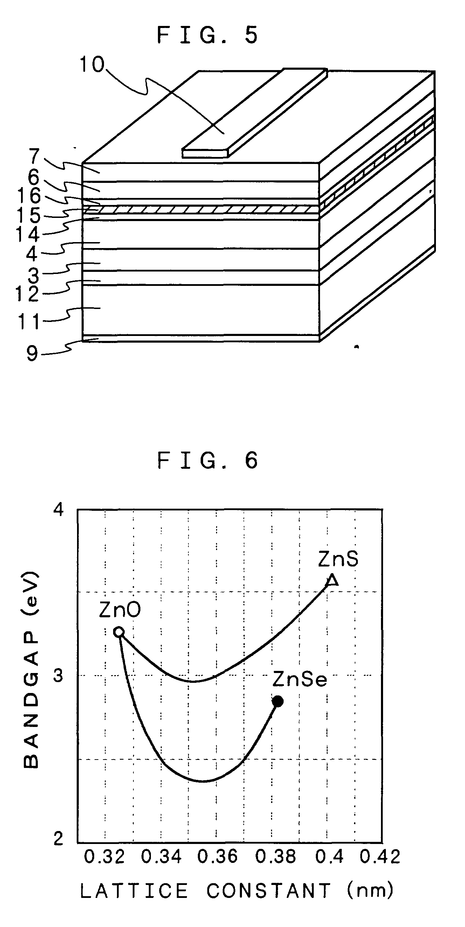

where c is a bowing parameter and can be split as c = $c_i+c_e$, in which $c_e$ can be expressed as $c_e = T_{BC}{}^2/S$ (S: constant), in which $T_{BC}$ represents a difference in electronegativity between elements B and C. For example, the electronegativity of As is 2.0 and that of P is 2.1, so that InGaAsP has a smaller value of c, in which case therefore the bowing phenomenon occurs scarcely even if the crystal mixture ratio between As and P is changed, whereas the electronegativity of O is 3.5 and those of S and Se are 2.5 and 2.4 respectively and so have a large difference with respect to that of O, so that ZnOS or ZnOSe gives the bowing phenomenon remarkably. This change in band gap in indicated in the graph of FIG. 6. The inventors found based on the above that like in the case of ZnO, even when ZnS and ZnSe themselves have a band gap too larger than a desired value, a desired band gap can be obtained by forming a mixed crystal compound such as ZnOS or ZnOSe.

Although this active layer 5 can be provided with a desired band gap as far as it contains Zn, O, and other group VI element as mentioned above, Zn may be replaced with any other group II type element, or it may contain two or more group VI type elements other than O such as S and Se. Also, it may of course contain such dopant elements as Al or N.

As mentioned above, to emit light with a wavelength of 400-430 nm easily, the crystal mixture ratio x of S in the active layer 5 expressed as $ZnO_{1-x}S_x$ or $ZnO_{1-y}Se_y$ is preferably 0.02-0.1 and more preferably 0.03-0.06, while the crystal mixture ratio y of Se is preferably 0.005-0.1 and more preferably 0.008-0.04. The crystal mixture ratio x and y, however, can be on the side of nearly 0 but also be on the side opposite of the parabola with respect to its minimal point (where x and y take on a larger value) in order to obtain a desired band gap.

In the embodiment shown in FIG. 1, the n-type and p-type clad layers 4 and 6 are of $Mg_zZn_{1-z}O$ (0≤z<1: e.g., z = 0.15). The clad layers 4 and 6 only have to have a larger band gap than the active layer 5 to thereby confine carriers in therein effectively and so may be made of any other group III nitride compound (gallium nitride based compound semiconductor) as far as it gives that confinement effect. $Mg_zZn_{1-z}O$, however, can be used to enable wet etching unlike by a gallium nitride based compound semiconductor and so is preferably in manufacturing of an LD described later because it facilitates constructing a mesa shape or incorporating an internal current restricting layer. This n-type clad layer 4 is formed to a thickness of, e.g. 2 μm or so and the p-type clad layer 6, e.g. 0.5 μm or so.

Although the substrate 1 is made of, e.g. sapphire, it is possible to use a GaN substrate, a silicon substrate on which SiC is formed, or mono-crystal SiC substrate also in a case where the clad layer is formed of a gallium nitride based compound semiconductor. On the surface of the substrate 1 is formed to a thickness of approximately 0.1 μm a buffer layer 2 made of, e.g. ZnO, for relaxing lattice mismatching in the compound semiconductor. This buffer layer 2 may be of a non-doped type or of the other conductivity type as far as the substrate 1 is made of an insulating material such as sapphire. If, however, the substrate 1 is electrically conductive so that one electrode is take out from its back side, the buffer layer 2 is formed to have the same conductivity type as that of the substrate 1. Thereon is formed an n-type contact layer 3 made of ZnO to a thickness of 1-2 μm or so.

On the p-type clad layer 6 is provided a p-type contact layer 7 made of ZnO to a thickness of 0.3 μm or so, on which is in turn formed a transparent electrode 8 made of, e.g. ITO and, at the same time, an n-side electrode pad 9 is formed, by vacuum evaporation and patterning or lift-off of Ti, Au, etc., on a portion of the n-type contact layer 3 exposed by removing the laminated semiconductor layers 3-7 partially by etching and a p-side electrode 10 made of Ni/Al/Au or the like is formed by lift-off or the like on a portion of the transparent electrode 8.

To manufacture this LED, the substrate 1 is set in, e.g. an MOCVD apparatus and heated to 300-600 °C or so to then act in a vapor phase with a necessary dopant gas introduced together with a carrier gas $H_2$ in order to grow a semiconductor layer, so that by changing the reactive gas sequentially or changing its flow rate, it is possible to laminate semiconductor layers at a desired crystal mixture ratio. In this case, as the reactive gas is employed dimethyl zinc $(Zn(C_2H_5)_2)$ for Zn, tetrahydro-furan $(C_4H_8O)$ for O, cyclopentadiethyl-magnesium $(Cp_2Mg)$ for Mg, diethyl-sulfide (DES) for S, or diethyl-selenium (DESe) for Se and, as fir the dopant gas, for Al, trimethyl-aluminium (TMA) is supplied as an n-type dopant gas and plasma $N_2$ is supplied as a p-type dopant gas. By controlling the reaction time, the thickness of the above-mentioned semiconductor layers can be controlled.

Then, thus laminated semiconductor layers are partially etched off by RIE etc. to expose the n-type contact layer 3. Afterward, the back side of the substrate 1 is polished to reduce its thickness to 100 μm or so, so that subsequently, on the surface of thus exposed n-type contact layer 3 are deposited by vacuum evaporation films of Ti/Au etc. with a lift-off method to form the n-side electrode pad 9, while on the surface of the p-type contact layer 7 is deposited by vacuum evaporation etc. a film of ITO to form the transparent electrode 8 and, at the same time, are deposited by vacuum evaporation films of Ni/Al/Au by a lift-off method etc. to form the p-side electrode 10. Then, by scribing the relevant wafer into chips, an LED chip such as shown in FIG. 1 is obtained.

Although this embodiment has employed such a method of growing ZnO-based compound semiconductor layers by MOCVD, the clad layers and so on other than the active layer can be formed of group III nitride compound such as, GaN-based or AlGaN-based compound. In this case, the group III nitride compound semiconductor layers can be grown at about 1000 °C and the active layer can be grown at the above-mentioned temperature of 600 °C to grow all the layers with good crystallinity. Also, particularly when the clad layers and the like are made of a ZnO-based compound, an MBE (Molecular Beam Epitaxy) method is preferable in the respects of an impurity of materials and safety, so that to manufacture this LED by MBE, the sapphire substrate 1 is set in, e.g. an MBE apparatus and heated to 300-600 °C or so to then grow the layers by opening the shutters of necessary material sources such as a Zn source (cell), an Mg source, a plasma oxygen source, S or Se source, an Al source as a dopant, a plasma nitrogen source, or the like.

FIG. 2 is a perspective view for explaining an electrode stripe-type LD chip of another embodiment of the semiconductor light emitting device according to the present invention. This LD chip also has the same construction as that of the LED chip of FIG. 1 except mainly that to provide an LD, light guide layers 14 and 16 are provided between the active layer 15 and each of the clad layers and also that the active layer 15 is formed in a quantum well structure.

That is, on the sapphire substrate 1 is formed the buffer layer 2 made of ZnO to a thickness of 0.1 μm or so, on which is formed the n-type contact layer 3 made of ZnO to a thickness of 1 μm or so. Thereon is in turn formed the n-type clad layer 4 made of $Mg_zZn_{1-z}O$ ($0 \leq z < 1$, e.g. z = 0.15) to a thickness of 2 μm or so, on which is formed the n-type light guide layer 14 made of n-type ZnO and constituting part of an optical wave-guide path to a thickness of 0.05 μm. The active layer 15 is formed in a multiple-quantum well structure which laminates therein barrier layers and well layers made of, e.g. non-doped $ZnO_{0.95}S_{0.05}/ZnO_{0.98-1.0}S_{0.02-0}$ to thicknesses of 5 nm and 4 nm respectively two through 5 layers each. When ZnOSe is used to form the active layer, the same combination of the barrier and well layers can be used which are made of $ZnO_{0.97}Se_{0.03}/ZnO_{0.9-1.0}Se_{0.1-0}$.

On the active layer 15 are formed a p-type light guide layer made of ZnO and constituting part of the optical wave-guide path to a thickness of 0.05 μm or so and the p-type clad layer 6 made of $Mg_zZn_{1-z}O$ ($0 \leq z < 1$,

e.g. z = 0.15) to a thickness of 2 $\mu$m or so, on which is in turn formed the p-type contact layer 7 made of ZnO to a thickness of 1 $\mu$m or so. Like in the case of an LED chip, on the surface of the n-type contact layer 3 exposed by removing by etching part of the laminated semiconductor layers is provided the n-side electrode 9 made of Ti/Au, while on the surface of the p-type contact layer 7 is formed the p-side electrode 10 made of, e.g., Ni/Al/Au. In the case of a semiconductor laser, since light is not emitted from the upper face but from an end face of the active layer 15, the upper face need not have a transparent electrode thereon and, therefore, to create a current path, the p-side electrode 10 formed in a stripe with a width of, e.g. 10 $\mu$m or so is directly formed on the p-type contact layer 7.

Since even when forming such an LD chip also, the semiconductor layers to be laminated one on another are made of a semiconductor oxide, the active layer is improved in crystallinity and can be easily etched to enable wet etching, so that even when the substrate is made of sapphire and so cannot easily be cleaved, the light emitting face of the end face of the active layer can be easily formed in a flat face, thus making it possible to easily form a good resonator.

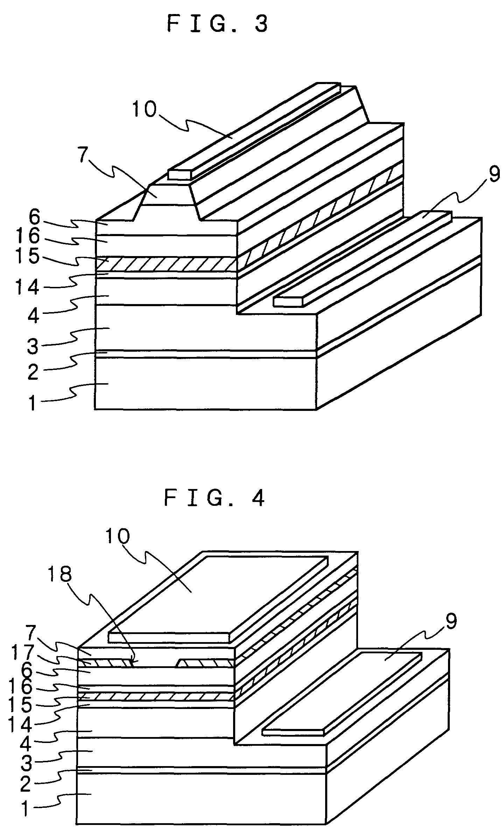

FIG. 3 is a perspective view for explaining the LD chip of a further embodiment of the semiconductor light emitting device of the present invention. This embodiment employs a mesa stripe-type construction in which instead of a stripe only of the p-side electrode 10, a part of the p-type clad layer 6 is also etched off in a mesa shape, in which case this mesa-type etching is achieved only by re-forming the mask at the same time as performing etching to expose the n-type contact layer 3. The lamination structure of the other semiconductor layers is the same as that shown in FIG. 2, with the same manufacturing method employed also.

FIG. 4 is a similar perspective view for explaining the LD chip of a still further embodiment of the semiconductor light emitting device of the present invention. This embodiment exemplifies an SAS-type construction in which an n-type current restricting layer (internal current blocking layer) 17 on the side of the p-type clad layer 6. To manufacture an LD chip of such a construction, almost the same way as above, on the substrate 1 are laminated the buffer layer 2, the n-type contact layer 3, the n-type clad layer 4, the n-type light guide layer 14, the active layer 15, the p-type light guide layer 16, and the p-type clad layer 6 in this order, on which is then grown the current restricting layer 17 made of , e.g. n-type $Mg_{0.2}Zn_{0.8}O$, to a thickness of 0.4 $\mu$m or so.

Then, the relevant wafer is once taken out from the growing apparatus, to deposit a resist film on the surface and pattern it into a stripe shape, thus etching the current restricting layer 17 using an alkaline solution such as NaOH into a stripe shape to then form the stripe groove 18. Afterward, the wafer is put back into the MOCVD apparatus to grow the p-type contact layer 7 made of p-type ZnO in the same way as the above-mentioned example. Then, almost the same way as the above-mentioned embodiments, the n-side electrode 9 and the p-side electrode 10 are formed to provide a chip, thus giving an LD chip having such a construction as shown in FIG. 4. In this case, the p-type clad layer 6 may be made in two stages in construction, to form the current restricting layer 17 therebetween.

Since in a prior art blue type semiconductor light emitting device, the lamination structure employing a gallium nitride based compound semiconductor is, as mentioned above, resistant against chemicals, it has been impossible to etch off such semiconductor layers as laminated in this embodiment to form a stripe groove, thus disabling sufficiently concentrating current paths up to the vicinity of the active layer, to guard against which, however, ZnO-based compound can be used to thereby incorporate into semiconductor layers a current restricting layer (internal current blocking layer) 17 having such a stripe groove formed therein.

FIG. 5 is a similar perspective view for explaining an still further embodiment of the LD chip of the semiconductor light emitting device according to the present invention. In this embodiment, the substrate is made of a conductive material in place of sapphire and, as a result, has the n-side electrode 9 provided on a back side of the substrate 11. In this embodiment, as the substrate is used a silicon (Si) substrate 11, on the surface of which is formed a cubic-crystal SiC layer 12, on which surface are laminated the above-mentioned semiconductor layers directly or via a buffer layer not shown. This SiC layer 12 is specifically formed by, for example, holding the Si substrate 11, for carbonization, in an atmosphere containing acetylene ($C_2H_2$) and hydrogen at about 1020 °C for 60 minutes or so to thereby form a SiC film, not shown, to a thickness of 10 nm or so and then by introducing dichloro-silane ($SiH_2Cl_2$), which is a Si source gas, and $C_2H_2$, which is a carbon source gas, in the same furnace to thereby grow the SiC film to a thickness of, e.g. 2 $\mu$m or so by thermal CVD method. Afterward, the semiconductor layers are laminated almost the same way as above. Although the etching-free construction employed in this embodiment, since the semiconductor layer lamination need not be grown at such a high temperature as required for a gallium nitride based compound semiconductor, then they can be grown at a low temperature of 600 °C or lower to thereby greatly mitigate the loads on the growing apparatus, thus facilitating its maintenance and the processes for growing the semiconductor layers. Further, that construction gives excellent crystallinity to the active layer, thus making it possible to obtain an LD and an LED having a good light emitting efficiency.

Although the embodiment shown in FIG. 5 employs an electrode stripe type construction for simplification, any construction of the above-mentioned embodiments including a current-restricting layer incorporating construction may be employed to thereby use the above-mentioned conductive substrate so that both the p-side and n-side electrodes may be taken out from the upper and back sides of the chip, thus providing such a device that is very easy to handle in, e.g. die bonding. Such a conductive substrate may be made of, besides a SiC crystal, GaN so that oxide semiconductor layers may be laminated thereon likewise.

Although in the above-mentioned embodiments, is used a multiple-quantum well structure as the active layer of LD, it may be formed in a single-quantum well structure or a bulk structure. Further, as far as the active layer can form light guide layer sufficiently, of course no separate light guide layer need to be provided thereon. Note here that in the figures showing the above-mentioned embodiments, the substrates 1 and 11 are a few tens of times as thick as the other layers but are shown much thinner. Also the thickness of the other semiconductor layers is not shown as it is.

Since by the present invention the band gap of ZnO can be narrowed without using a toxic element such as Cd, it is possible to provide a ZnO-based oxide semiconductor with a band gap ranging from ultraviolet to light having a wavelength of 400-430 nm required for a light source of a high-definition DVD, thus advantageously using a short-wavelength semiconductor light emitting device.

Also, since the semiconductor light emitting device according to the present invention employs a structure in which the active layer is made of a ZnO-based compound semiconductor and sandwiched by the clad layers, its crystallinity is not deteriorated unlike an InGaN-based compound semiconductor when blue type light is emitted, thus making it possible to keep good crystallinity of the active layer also capable of emitting light of a wavelength in the vicinity of 400-430 nm. This results in an improved light emitting efficiency and a semiconductor light emitting device having a highly bright blue color type.

Further, since the active layer is made of a ZnO-based compound semiconductor, by forming the clad layer of an oxide compound containing Zn or an oxide compound semiconductor containing Mg and Zn, such a semiconductor lamination can be formed that has good crystallinity to thereby enable wet etching difficult to perform in the case of a gallium nitride based compound semiconductor, formation of a semiconductor layer at a low temperature of 600 °C or lower, and other very easy handling jobs, thus obtaining a blue type semiconductor light emitting device easily. Although the semiconductor laser needs to define a region into which a current is injected, the invention enables easy burying and mesa-type etching of a current restricting layer, thus giving large merits.

Further, since the above-mentioned ZnO-based compound semiconductor layer can be grown even on SiC on a Si substrate or on a SiC substrate, such a vertical type chip can be configured that is cable of taking the two electrode from the upper and back sides thereof each. This results in a wire bonding process required only to one of the two electrode, thus greatly improving the ease-to-handle.

By the present invention, it is possible to emit blue type light using a ZnO-based oxide semiconductor layer in place of the conventional gallium nitride based compound semiconductor even without using a toxic element such as Cd, thus obtaining a semiconductor light emitting device with a high light emitting efficiency due to practical semiconductor layers with excellent in crystallinity without producing pollution.

Also, the present invention enables to use a ZnO-based oxide semiconductor without taking a pollution problem into account to thereby laminate semiconductor layers at a very lower temperature than a gallium nitride based compound semiconductor. As a result, it is possible to mitigate loads on the growing apparatus and also carry out wet etching to provide an easy-to-handle and stable semiconductor lamination.

Although preferred examples have been described in some detail it is to be understood that certain changes can be made by those skilled in the art without departing from the spirit and scope of the invention as defined by the appended claims.

In such a construction that an active layer (5) for emitting light when a current is injected thereto is sandwiched between an n-type clad layer (4) and a p-type clad layer (6) which are made of a material having a larger band gap than that of the active layer, the above-mentioned active layer (5) is made of a compound semiconductor containing Zn, o, and a group VI type element other than O. As a result, it is possible to obtain such a semiconductor light emitting device as a blue type LED or LD, which is made of the harmless material and does not include Cd specifically, while using a ZnO-based compound semiconductor of narrow band gap with fewer crystal defects and excellent in crystallinity as a material of its active layer sandwiched between clad layers, and also improving its light emitting properties.

**Claims**

1. A semiconductor light emitting device comprising:

   an active layer for emitting light when a current is injected thereto; and
   an n-type clad layer and a p-type clad layer which are made of a material having a larger band gap than said active layer and which sandwich said active layer therebetween,

   wherein said active layer is made of a compound semiconductor containing Zn, O, and a group VI element other than O.

2. The semiconductor light emitting device of claim 1, wherein said clad layer is made of an oxide compound semiconductor containing Zn or an oxide compound semiconductor containing Mg and Zn.

3. The semiconductor light emitting device of claim 1, wherein said n-type and p-type clad layers are made of a group III nitride compound semiconductor.

4. The semiconductor light emitting device of claim 1, wherein said active layer is made of $ZnO_{1-x}S_x$ or $ZnO_{1-y}Se_y$.

5. The semiconductor light emitting device of claim 1, wherein said active layer contains Zn, O, S, and Se.

6. A semiconductor laser comprising:

an active layer for emitting light when a current is injected thereto; and
an n-type clad layer and a p-type clad layer which are made of a material having a larger band gap than said active layer and which sandwich said active layer therebetween,

wherein said active layer is made of a bulk layer of $ZnO_{1-x}S_x$ or $ZnO_{1-y}Se$ or a quantum well structure obtained by modifying a composition of $ZnO_{1-x}S_x$ or $ZnO_{1-y}Se_y$.

7. The semiconductor laser of claim 6, wherein said active layer is provided with light guide layers on both sides thereof.

8. The semiconductor laser of claim 6, wherein a stripe-shaped electrode is formed on a surface of a semiconductor lamination including said n-type clad layer, said active layer, and said p-type clad layer, and wherein a current injecting region in said active layer is defined along a shape of said stripe-shaped electrode.

9. The semiconductor laser of claim 6, wherein etching for forming a mesa-type shape is carried out from a surface of a semiconductor lamination including said n-type clad layer, said active layer, and said p-type clad layer to part of an upper layer of said n-type clad layer or said p-type clad layer, and wherein a current injecting region in said active layer is defined along a shape of said mesa-type shape.

10. The semiconductor laser of claim 6, wherein a current restricting layer having a stripe groove is formed in either one of said n-type clad layer or p-type clad layer, and wherein a current injecting region in said active layer is defined along a shape of said stripe groove.

11. The semiconductor light emitting device of claim 1, wherein a substrate for forming thereon a semiconductor lamination including said n-type clad layer, said active layer, and said p-type clad layer is made of conductive material.

# FIG. 1

# FIG. 2

FIG. 3

FIG. 4

# F I G. 5

# F I G. 6

# FIG. 7
## PRIOR ART

**European Patent Office**

## EUROPEAN SEARCH REPORT

Application Number

EP 01 11 5378

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 1997, no. 10, 31 October 1997 (1997-10-31) -& JP 09 162500 A (SONY CORP), 20 June 1997 (1997-06-20) | 1,4-7,11 | H01L33/00 H01S5/327 H01S5/347 |
| Y | * abstract * * paragraph '0019!; figures * | 8-10 | |
| X | PATENT ABSTRACTS OF JAPAN vol. 1999, no. 11, 30 September 1999 (1999-09-30) -& JP 11 150337 A (SONY CORP), 2 June 1999 (1999-06-02) * abstract; figures * | 1,4-7,11 | |
| A | PATENT ABSTRACTS OF JAPAN vol. 1999, no. 13, 30 November 1999 (1999-11-30) -& JP 11 238914 A (YOSHIKAWA AKIHIKO;MITSUBISHI CHEMICAL CORP), 31 August 1999 (1999-08-31) * abstract * * paragraph '0016! * | 1,4-6 | TECHNICAL FIELDS SEARCHED (Int.Cl.7) H01L H01S |
| Y | WO 00 16411 A (ROHM CO LTD ;NAKAHARA KEN (JP); TANABE TETSUHIRO (JP)) 23 March 2000 (2000-03-23) | 8-10 | |
| A | * abstract; figures * & EP 1 115 163 A (ROHM CO LTD) 11 July 2001 (2001-07-11) * page 4, line 3-24 * * page 13, line 41 - page 15, line 6; figures 2-5 * | 2,3 | |

The present search report has been drawn up for all claims

| Place of search | Date of completion of the search | Examiner |
|---|---|---|
| THE HAGUE | 16 October 2001 | De Laere, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 01 11 5378

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2001

| Patent document cited in search report | | Publication date | Patent family member(s) | | Publication date |
|---|---|---|---|---|---|
| JP 09162500 | A | 20-06-1997 | NONE | | |
| JP 11150337 | A | 02-06-1999 | NONE | | |
| JP 11238914 | A | 31-08-1999 | NONE | | |
| WO 0016411 | A | 23-03-2000 | EP | 1115163 A1 | 11-07-2001 |
| | | | WO | 0016411 A1 | 23-03-2000 |

EPO FORM P0459

For more details about this annex : see Official Journal of the European Patent Office, No. 12/82